# EUROPEAN PATENT APPLICATION

(11) **EP 4 583 636 A1**
(43) Date of publication of application: **09.07.2025**
(21) Application number: 23859377.6
(22) Date of filing: 30.08.2023
(51) Int. Cl.: H05B 6/02, H05B 6/12

(54) **ELECTROMAGNETIC HEATING DEVICE**

(30) Priority: 02.09.2022 CN 202222333091 U
(71) Applicant: Foshan Shunde Midea Electrical Heating Appliances Manufacturing Co., Ltd., Foshan, Guangdong 528311 (CN)
(72) Inventor: ZHANG, Ren, Foshan, Guangdong 528311 (CN); LU, Yu, Foshan, Guangdong 528311 (CN); ZHANG, Youzhi, Foshan, Guangdong 528311 (CN); LV, Shunzhao, Foshan, Guangdong 528311 (CN); QIN, Qiong, Foshan, Guangdong 528311 (CN); WANG, Zhifeng, Foshan, Guangdong 528311 (CN)
(74) Representative: Ran, Handong
(86) International application number: PCT/CN2023/115726
(87) International publication number: WO 2024/046348

(57) **Abstract**

An electromagnetic heating device (100), comprising: a housing (110), comprising an air inlet (112) and an air outlet (114), the air inlet (112) being located at the bottom of the housing (110), and the air outlet (114) being located on a peripheral side of the housing (110); and a fan assembly (120), disposed inside the housing (110) and opposite to the air inlet (112), and configured to generate airflows that diffuses toward peripheral sides of the fan assembly (120). By arranging the air inlet (112) and the air outlet (114) in the above manner, and by providing the fan assembly (120) capable of diffusing airflows in all directions, diffused airflows can cover the entire internal space of the housing (110), and heating structures around the fan assembly (120) can all come into contact with heat dissipation airflow and perform heat exchange with heat dissipation airflows. The application remedies the technical defect in the related art in which products have high heat dissipation pressure and poor heat dissipation performance.

## Description

This application claims priority to Chinese Patent Application No. 202222333091.3 filed with China National Intellectual Property Administration on September 2, 2022 and entitled "ELECTROMAGNETIC HEATING DEVICE", the entire contents of which are herein incorporated by reference.

### FIELD

The present application relates to the technical field of electromagnetic heating, and specifically relates to an electromagnetic heating device.

### BACKGROUND

In related art, to meet the heat dissipation requirement of a multi-head stove, an air inlet and an air outlet oriented in a specific direction are typically provided in a casing. Then the airflow passing through the air inlet and the air outlet sequentially carries away internal heat. However, a single-direction heat-dissipating airflow cannot ensure covering all internal heat-generating structures, and this leads to the technical effects of high heat dissipation pressure and poor heat dissipation effect in the multi-head stove.

Therefore, how to overcome the above technical defects has become a technical problem that needs to be solved urgently.

### SUMMARY

The present application aims to solve at least one of the technical problems in the prior art.

Therefore, one aspect of the present application provides an electromagnetic heating device.

In view of this, the present application provides an electromagnetic heating device. The electromagnetic heating device comprises: a housing comprising an air inlet and an air outlet, and the air inlet is located at the bottom of the housing, and the air outlet is located in a peripheral side of the housing; and a fan assembly, disposed inside the housing and being opposite to the air inlet, and configured to generate an airflow that diffuses toward the peripheral sides of the fan assembly.

The present application defines an electromagnetic heating device that can generate an electromagnetic field. A target container is placed above the electromagnetic heating device, and under the action of the electromagnetic field, the temperature of the target container gradually increases, to cook the food ingredients into finished food through the high-temperature target container.

The electromagnetic heating device comprises the housing and the fan assembly. The housing serves as the main frame structure of the electromagnetic heating device, and is configured to position and support other structures on the electromagnetic heating device, for example, an electromagnetic heating assembly that generates the electromagnetic field is installed inside the housing. And the housing is provided with the air inlet and the air outlet, and the fan assembly is arranged inside the housing. The fan assembly drives the air to flow within the housing to generate a heat dissipation airflow. The heat dissipation airflow enters the interior of the housing through the air inlet and is discharged outside the housing through the air outlet, to carry away the heat from the working structures inside the housing, thus achieving the heat dissipation effect.

In related art, for products such as the multi-head stove and an induction cooker, the electrical members inside the casing generate a large amount of heat during operation. Moreover, part of the heat from the heated target container is further transferred to the interior of the casing. To dissipate the abovementioned heat, a heat dissipating air duct is often constructed inside the casing.

In related art, to meet the heat dissipation requirement of a multi-head stove, an air inlet and an air outlet oriented in a specific direction are typically provided in a casing. Then the airflow passing through the air inlet and the air outlet sequentially carries away internal heat. However, a single-direction heat-dissipating airflow cannot ensure covering all internal heat-generating structures, and this leads to the technical defects of high heat dissipation pressure and poor heat dissipation effect in the multi-head stove. However, the heat dissipation airflow generated by the air outlet with a single orientation has limited coverage area, and this situation is highly likely to create a heat dissipation dead corner, rendering it impossible to ensure that the heat dissipation airflow can cover all heating structures within the housing. Consequently, the heat dissipation airflow cannot meet the actual heat dissipating demands of the product, resulting in the technical problems of poor heat dissipation effect, low safety, and a high failure rate of the product.

In this regard, in the electromagnetic heating device defined in the present application, the air inlet is provided at the bottom of the housing, while the air outlet is provided in the peripheral side of the housing, and the air outlet can face a plurality of directions in the peripheral side of the housing. On this basis, the fan assembly is arranged relative to the air inlet. When activated, the fan assembly diffuses the air drawn in from the air inlet to the peripheral side of the fan assembly, and the diffused airflow finally gathers in the area where the air outlet is located and is discharged out of the housing through the air outlet. By arranging the air inlet and the air outlet in the above manner and providing a fan assembly that can diffuse airflow in all directions, the diffused airflow can cover the entire internal space of the housing, and this allows the heating structures around the fan assembly to come into contact with the heat dissipation airflow and perform heat exchange with the heat dissipation airflow. Even if there is no air outlet in a certain direction, the airflow moving in that direction can still dissipate the heat for the heating members in the area it passes through, and finally gather at the air outlet and is discharged through the air outlet.

Thus, it can be seen that the present application overcomes the technical defects of high heat dissipation pressure and poor heat dissipation effect of the product in related art by providing the air outlet in the peripheral side of the housing and providing the fan assembly that diffuses airflow in all directions. Furthermore, the technical effects of optimizing the structural layout of electromagnetic heating device, improving the safety and reliability of electromagnetic heating device, and reducing the failure rate of electromagnetic heating device are achieved.

In addition, the electromagnetic heating device provided in the present application may further have the following additional technical features:

In some technical solutions, the air outlet comprises: a first air outlet located on the front side and/or the rear side of the housing; a second air outlet located at the left side and/or the right side of the housing.

In this technical solution, the orientation of the air outlet is defined. Specifically, the peripheral side of the housing comprises a front side, a rear side, a left side and a right side. According to the orientation of the air outlet, it is divided into the first air outlet and the second air outlet. And the first air outlet is provided on the front side and/or the rear side of the housing, and the second air outlet is provided on the left side and/or the right side of the housing. That is, the air outlet can be arranged in two adjacent directions in the peripheral side of the housing, or the air outlet can further be arranged in all four directions in the peripheral side of the housing. By arranging the air outlet in at least two adjacent directions, the coverage area of the heat dissipation airflow inside the housing can be expanded, and this can avoid that the heat dissipation airflow gathering in a single direction cannot cover the internal space of the entire housing and then a heat dissipation dead corner is generated. Furthermore, the technical effects of optimizing the distribution of the air outlet, improving the coverage of the heat dissipation airflow, enhancing heat dissipation efficiency, and improving the safety and reliability of the electromagnetic heating device are achieved.

In some technical solutions, the first air outlet is only provided on the front side of the housing or the rear side of the housing; the second air outlet is provided on both the left side of the housing and the right side of the housing.

In this technical solution, the orientation of the air outlet is further defined. Specifically, the second air outlet is provided on both the left side of the housing and the right side of the housing. The first air outlet is only provided on one side of the front and rear sides of the housing. By defining the above distribution manner of the air outlet in which air is discharged from three sides, it is possible to improve the intensity of the heat dissipation airflow by appropriately reducing the orientation of the air outlet and the total area of the air outlet on the basis of ensuring that the coverage of the internal space of the housing by the heat dissipation airflow meets the heat dissipation requirements, to enhance the heat dissipation efficiency.

Furthermore, the first air outlet is only provided on the front side of the housing, and the rear side of the electromagnetic heating device is often arranged close to the wall. Providing the first air outlet only on the front side of the housing can avoid the phenomenon that the air outlet is blocked by the wall and the air cannot be discharged smoothly. Furthermore, the technical effect of improving the practicality of electromagnetic heating device is achieved.

In some technical solutions, the fan assembly comprises: a first air supply part, spaced apart from the first air outlet and configured to deliver airflow to the first air outlet; a second air supply part, located between the first air supply part and the first air outlet and configured to deliver airflow to the second air outlet.

In this technical solution, the fan assembly comprises the first air supply part and the second air supply part. Specifically, the first air supply part is spaced apart from the first air outlet, and the second air supply part is provided between the first air outlet and the first air supply part. Taking only providing the first air outlet on the front side of the housing as an example, the first air supply part is provided near the rear side of the housing, and the second air supply part is provided on the front side of the first air supply part. Taking providing the first air outlet on both of the front side and the rear side of the housing as an example, the first air supply part is provided in a central area, and the second air supply part is provided on both of the front side and the rear side of the first air supply part.

And the first air supply part is configured to generate a first airflow flowing towards the first air outlet, that is, the first airflow flows from the first air outlet towards the front side and/or the rear side of the housing to cover the heating structure in the front and rear spaces of the first air supply part through the first airflow. The second air supply part simultaneously delivers a second airflow to the two second air outlets in the left and right sides of the housing, and the second airflow mainly carries away the heat from the heating structures on the left and right sides of the second air supply part. By arranging the second air supply part between the first air supply part and the first air outlet, the first airflow and the second airflow can intersect and converge on the left and right sides of the second air outlet, to improve the heat dissipation efficiency of the space on the left and right sides of the second air supply part. Furthermore, the technical effects of improving the heat dissipation effect of the electromagnetic heating device and enhancing the safety and reliability of electromagnetic heating device are achieved.

Furthermore, the heating structures within the housing are concentrated on the left and right sides of the second air supply part, to achieve centralized heat dissipation through the intersecting first and second airflow.

In some technical solutions, a plurality of second air supply parts are provided between the first air supply part and the first air outlet.

In this technical solution, a plurality of second air supply parts are provided between the first air supply part and the first air outlet. Each second air supply part delivers the second airflow to the second air outlets on both the left and right sides, to jointly conduct heat dissipation for the heating structures on the left and right sides through the plurality of second air supply parts.

By arranging a plurality of second air supply parts between the first air supply part and the first air outlet, the heat dissipation pressure on the left and right sides can be shared, and this reduces the air supply demand of a single second air supply part, and then reduces the size of a single second air supply part to avoid excessive occupation of the space on the left and right sides by an overly large second air supply part, to provide convenient conditions for the layout of the heating structures inside the housing. As a result, the technical effects of improving the utilization rate of the heat dissipation airflow and enhancing the heat dissipation efficiency are achieved.

In some technical solutions, the air inlet extends along a first direction, and the first air supply part and the second air supply part are distributed along the first direction; the first direction is from the front side of the housing to the rear side of the housing.

In this technical solution, the shape of the air inlet and the corresponding distribution manner of the air supply parts are described. Specifically, the air inlet is strip-shaped, and the strip-shaped air inlet extends along the first direction at the bottom of the housing. The first direction is from the front side of the housing to the rear side of the housing, that is, the thickness direction of the housing. On this basis, the first air supply part and the second air supply part further extend along the thickness direction, to reduce the occupation of the space on the left and right sides of the air supply parts as much as possible, and provide convenient conditions for the rational layout of the heating structures.

Furthermore, the air inlet is distributed along the middle line of the housing, to divide the space into two symmetrical spaces on the left and right sides of the air inlet, and this enhances the uniformity of the heat dissipation airflow, reduces the possibility of the appearance of obvious strong heat dissipation area and weak heat dissipation area, and further enhance the reliability of heat dissipation.

In some technical solutions, the first air supply part comprises: a first fan, positioned opposite the air inlet; and a first air guiding rib, surrounding the first fan and comprising a first opening that faces the area between the second air supply part and the second air outlet.

In this technical solution, the structure of the first air supply part is described. Specifically, the first air supply part comprises a first fan and a first air guiding rib. The intake side of the first fan faces the air inlet at the bottom of the housing, while the discharge side of the first fan faces all the directions of the first fan. The first fan draws air in from the air inlet and discharges the pressurized air to the surrounding area. The first air guiding rib is provided on the peripheral side of the first fan and surrounds the first fan, and the first air guiding rib is provided with a first opening. The first opening avoids the second air supply part and faces the left and right sides of the second air supply part. When the first fan operates, the airflow that is diffused in all directions encounters the first air guiding rib and then converges towards the first opening along the first air guiding rib. Finally, the airflow flows towards the area that the first opening faces to form the aforementioned first airflow.

Furthermore, the first air guiding rib comprises two first openings, and one of the first openings faces the left front side of the first air supply part, namely, the area on the left side of the second air supply part, and the other first opening faces the right front side of the first air supply part, namely, the area on the right side of the second air supply part. The structure complexity of the air supply parts composed of the fan and the air guiding rib is relatively low, which can reduce process complexity and the cost of production and assembly.

In some technical solutions, the second air supply part comprises: a second fan, positioned opposite the air inlet; and a second air guiding rib, surrounding the second fan and comprising a second opening that faces the second air outlet.

In this technical solution, the structure of the second air supply part is described. Specifically, the second air supply part comprises a second fan and a second air guiding rib. The intake side of the second fan faces the air inlet at the bottom of the housing, while the discharge side of the second fan faces all the directions of the second fan. The second fan draws air in from the air inlet and discharges the pressurized air to the surrounding area. The second air guiding rib is provided on the peripheral side of the second fan and surrounds the second fan, and the second air guiding rib is provided with a second opening. The second opening faces the two second air outlets on the left and right sides of the second air supply part. When the second fan operates, the airflow that is diffused to all directions encounters the second air guiding rib and then converges towards the second opening along the second air guiding rib. Finally, the airflow is discharged to the second air outlets to form the aforementioned second airflow.

Furthermore, the second air guiding rib comprises two second openings, and one of the second openings faces the area on the left side of the second air supply part and delivers airflow to the second air outlet on the left side of the housing, and the other second opening faces the area on the right side of the second air supply part and delivers airflow to the second air outlet in the right side of the housing. Likewise, the structure complexity of the air supply parts composed of the fan and the air guiding rib is relatively low, which can reduce process complexity and the cost of production and assembly.

In some technical solutions, both the first fan and the second fan are axial fans.

In this technical solution, an axial fan is selected as both the first fan and the second fan. The axial fan is characterized by an internal airflow that is parallel to the axial direction of a wind wheel and an output airflow that is close to the radial direction of the wind wheel, and can meet the need of drawing in air from the bottom and discharging air from the peripheral side. Additionally, the axial fan has a relatively low requirement for size in a height direction, and selecting the axial fan helps reduce the thickness of the electromagnetic heating device, and then reduces the difficulty of arranging and storing the electromagnetic heating device, and improves the practicality of the electromagnetic heating device.

In some technical solutions, the impeller diameter of the first fan is greater than that of the second fan.

In this technical solution, based on the previous technical solution, the impeller diameter of the first fan is a first diameter, and the impeller diameter of the second fan is a second diameter. Here, the first diameter is greater than the second diameter.

By providing the first fan with a larger impeller diameter, the space on the left and right sides of the first air supply part can be fully utilized to generate strong first airflow by increasing the impeller size, to enhance the heat dissipation effect on the left and right sides of the second air supply part.

By providing the second fan with a smaller impeller diameter, it is possible to avoid excessive occupation of the space on the left and right sides by the impeller, reduce the possibility of interference between the second air supply part and the heating structures, and provide convenient conditions for arranging the heating structures on the left and on the right.

In some technical solutions, the electromagnetic heating device further comprises a main board provided between the air outlet and the fan assembly.

In this technical solution, the aforementioned heating structures comprise a main board, and the main board comprises a PCB (Printed Circuit Board), and a control chip, a power supply unit, a sensor, a switch tube, etc. provided on the PCB. The main board is configured to control the working status of the electromagnetic heating device to meet the automation and intelligence requirements of the electromagnetic heating device. And the main board generates a large amount of heat after being powered on. If this heat cannot be dissipated in time to the outside, problems such as the circuit breakage of the main board, melting and even combustion may occur. In this regard, the present application arranges the main board between the air outlet and the fan assembly, specifically between the second air supply part and the second air outlet, to jointly cool the main board through the aforementioned first airflow and second airflow, to reduce the possibility of the occurrence of the above problems of the main board and then achieve the technical effect of improving the safety and reliability of the electromagnetic heating device.

In some technical solutions, the electromagnetic heating device further comprises a heat sink, arranged on the main board.

In this technical solution, the electromagnetic heating device further comprises a heat sink, arranged on the main board and located within the coverage range of the first airflow and the second airflow. The heat sink has excellent thermal conductivity and can specifically choose an aluminum alloy heat sink. During operation, the heat generated by the main board is transferred to the heat sink through contact. As the first airflow and the second airflow flow through the heat sink, the heat inside the heat sink is quickly dissipated into the first airflow and the second airflow, to accelerate the heat dissipation efficiency of the main board, and then enhance the heat dissipation effect without changing fan power.

In some technical solutions, the housing comprises: a bottom plate, with the air inlet arranged in the bottom plate; a side plate, which is connected to the bottom plate and surrounds the bottom plate. The air outlet is arranged in the side plate.

In this technical solution, the structure of the housing is described. Specifically, the housing comprises a bottom plate and a side plate. The air inlet is provided in the bottom plate. The side plate surrounds the bottom plate, and the air outlet is provided in the side plate. The bottom plate and the side plate enclose a cavity body. The main board, the fan assembly, and the heat sink are all provided within the cavity body to conceal and protect the abovementioned internal structures through the housing.

The side plate is detachably provided on the bottom plate. By setting the detachable side plate, firstly, the processing difficulty of the housing can be reduced, and secondly, when a side plate on a certain side is damaged or the air outlet on it is blocked, users can replace or clean the side plate by detaching the corresponding side plate. This reduces the maintenance difficulty of the housing and provides convenience for users.

In some technical solutions, the electromagnetic heating device further comprises a partition plate, which is connected to the side plate and spaced apart from the bottom plate. The fan assembly, the main board, and the heat sink are all located between the partition plate and the bottom plate.

In this technical solution, the electromagnetic heating device further comprises a partition plate. The partition plate is connected to the side plate, and the partition plate is spaced apart from the bottom plate. The partition plate is located at the top of the fan assembly, the main board, and the heat sink. By providing the partition plate, it can cooperate with the bottom plate, the side plate, and the aforementioned air guiding rib to enclose an air supply channel. Firstly, it can increase the airflow intensity by collecting the airflow to enhance the heat dissipation effect, and secondly, it can prevent the airflow from leaking out from the top, to further improve the heat dissipation effect and reduce energy consumption.

In some technical solutions, the electromagnetic heating device further comprises a panel arranged at the top of the housing.

In this technical solution, the electromagnetic heating device further comprises a panel. The panel is placed above the side plate. Firstly, users cover the opening in the top of the housing to conceal the working structures inside the housing, and secondly, the panel is configured to support a target container. Specifically, an electromagnetic coil inside the housing forms a heating area on the panel. The target container is placed above the heating area. Under the action of the electromagnetic field generated by the electromagnetic coil, the target container gradually heats up, to cook the food ingredients inside it at a high temperature.

The additional aspects and advantages of the present application will become apparent in the following description, or can be learned through the practice of the present application.

### BRIEF DESCRIPTION OF THE DRAWINGS

The above and/or additional aspects and advantages of the present application will become apparent and readily understandable from the description of the embodiments in combination with the following accompanying drawings.
FIG. 1 is a first schematic view of the structure of an electromagnetic heating device according to an embodiment of the present application;
FIG. 2 is a second schematic view of the structure of an electromagnetic heating device according to an embodiment of the present application;
FIG. 3 is a schematic view of the structure of a first air supply part according to an embodiment of the present application;
FIG. 4 is a third schematic view of the structure of an electromagnetic heating device according to an embodiment of the present application; and
FIG. 5 is a fourth schematic view of the structure of an electromagnetic heating device according to an embodiment of the present application.

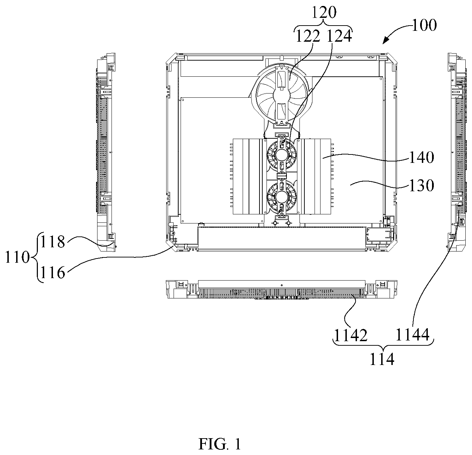

The corresponding relationships between the reference signs and the component names in FIG. 1 to FIG. 5 are as follows:
100 electromagnetic heating device, 110 housing, 112 air inlet, 114 air outlet, 1142 first air outlet, 1144 second air outlet, 116 bottom plate, 118 side plate, 120 fan assembly, 122 first air supply part, 1222 first fan, 1224 first air guiding rib, 124 second air supply part, 1242 second fan, 1244 second air guiding rib, 130 main board, 140 heat sink, 150 partition plate, 160 panel.

### DETAILED DESCRIPTION OF THE APPLICATION

To more clearly understand the above purposes, features and advantages of the present application, the present application will be further detailed hereinafter in combination with the accompanying drawings and embodiments. It should be indicated that in the case of no conflict, the embodiments and the features in the embodiments of the present application can be combined with each other.

Many details are illustrated in the following description for the convenience of a thorough understanding to the present application, but the present application can further be implemented using other embodiments other than these described herein. Therefore, the protection scope of the present application is not limited to the specific embodiments disclosed in the following text.

The electromagnetic heating device according to some embodiments of the present application will be described hereinafter referring to FIG. 1 to FIG. 5.

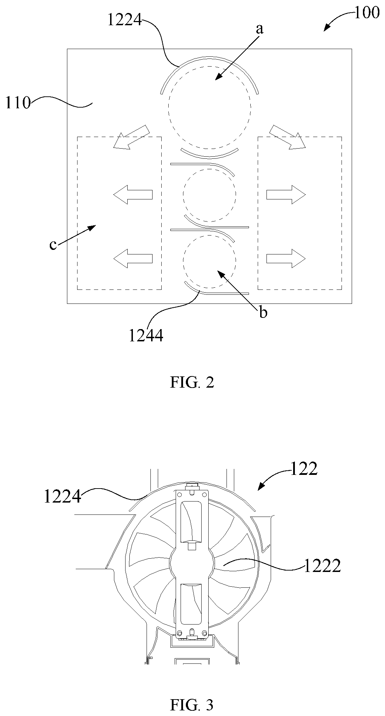

As shown in FIG. 1 and FIG. 2, an embodiment of the present application provides an electromagnetic heating device 100, and the electromagnetic heating device 100 comprises: a housing 110 comprising an air inlet 112 and an air outlet 114, and the air inlet 112 is located at the bottom of the housing 110, and the air outlet 114 is located in a peripheral side of the housing 110; and a fan assembly 120, disposed inside the housing 110 and being opposite to the air inlet 112, and configured to generate an airflow that diffuses toward the peripheral sides of the fan assembly 120.

The present application defines an electromagnetic heating device 100 that can generate an electromagnetic field. A target container is placed above the electromagnetic heating device 100, and under the action of the electromagnetic field, the temperature of the target container gradually increases, to cook the food ingredients into finished food through the high-temperature target container.

The electromagnetic heating device 100 comprises the housing 110 and the fan assembly 120. The housing 110 serves as the main frame structure of the electromagnetic heating device 100, and is configured to position and support other structures on the electromagnetic heating device 100, for example, an electromagnetic heating assembly that generates the electromagnetic field is installed inside the housing 110. And the housing 110 is provided with the air inlet 112 and the air outlet 114, and the fan assembly 120 is arranged inside the housing 110. The fan assembly 120 drives the air to flow within the housing 110 to generate a heat dissipation airflow. The heat dissipation airflow enters the interior of the housing 110 through the air inlet 112 and is discharged outside the housing 110 through the air outlet 114, to carry away the heat from the working structures inside the housing 110, thus achieving the heat dissipation effect.

In related art, for products such as the multi-head stove and an induction cooker, the electrical members inside the casing generate a large amount of heat during operation. Moreover, part of the heat from the heated target container is further transferred to the interior of the casing. To dissipate the abovementioned heat, a heat dissipating air duct is often constructed inside the casing.

In related art, to meet the heat dissipation requirement of a multi-head stove, an air inlet and an air outlet oriented in a specific direction are typically provided in a casing. Then the airflow passing through the air inlet and the air outlet sequentially carries away internal heat. However, a single-direction heat-dissipating airflow cannot ensure covering all internal heat-generating structures, and this leads to the technical effects of high heat dissipation pressure and poor heat dissipation effect in the multi-head stove. However, the heat dissipation airflow generated by the air outlet with a single orientation has limited coverage area, and this situation is highly likely to create a heat dissipation dead corner, rendering it impossible to ensure that the heat dissipation airflow can cover all heating structures within the housing. Consequently, the heat dissipation airflow cannot meet the actual heat dissipating demands of the product, resulting in the technical problems of poor heat dissipation effect, low safety, and a high failure rate of the product.

In this regard, in the electromagnetic heating device 100 defined in the present application, the air inlet 112 is provided at the bottom of the housing 110, while the air outlet 114 is provided in the peripheral side of the housing 110, and the air outlet 114 can face a plurality of directions in the peripheral side of the housing 110. On this basis, the fan assembly 120 is arranged relative to the air inlet 112. When activated, the fan assembly 120 diffuses the air drawn in from the air inlet 112 to the peripheral side of the fan assembly 120, and the diffused airflow finally gathers in the area where the air outlet 114 is located and is discharged out of the housing 110 through the air outlet 114. By arranging the air inlet 112 and the air outlet 114 in the above manner and providing a fan assembly 120 that can diffuse airflow in all directions, the diffused airflow can cover the entire internal space of the housing 110, and this allows the heating structures around the fan assembly 120 to come into contact with the heat dissipation airflow and perform heat exchange with the heat dissipation airflow. Even if there is no air outlet 114 in a certain direction, the airflow moving in that direction can still dissipate the heat for the heating members in the area it passes through, and finally gather at the air outlet 114 and is discharged through the air outlet 114.

Thus, it can be seen that the present application overcomes the technical defects of high heat dissipation pressure and poor heat dissipation effect of the product in related art by providing the air outlet 114 in the peripheral side of the housing 110 and providing the fan assembly 120 that diffuses airflow in all directions. Furthermore, the technical effects of optimizing the structural layout of electromagnetic heating device 100, improving the safety and reliability of electromagnetic heating device 100, and reducing the failure rate of electromagnetic heating device 100 are achieved.

As shown in FIG. 1 and FIG. 2, in some embodiments, the air outlet 114 comprises: a first air outlet 1142 located on the front side and/or the rear side of the housing 110; a second air outlet 1144 located at the left side and/or the right side of the housing 110.

In this embodiment, the orientation of the air outlet 114 is defined. Specifically, the peripheral side of the housing 110 comprises a front side, a rear side, a left side and a right side. According to the orientation of the air outlet 114, it is divided into the first air outlet 1142 and the second air outlet 1144. And the first air outlet 1142 is provided on the front side and/or the rear side of the housing 110, and the second air outlet 1144 is provided on the left side and/or the right side of the housing 110. That is, the air outlet 114 can be arranged in two adjacent directions in the peripheral side of the housing 110, or the air outlet 114 can further be arranged in all four directions in the peripheral side of the housing 110. By arranging the air outlet 114 in at least two adjacent directions, the coverage area of the heat dissipation airflow inside the housing 110 can be expanded, and this can avoid that the heat dissipation airflow gathering in a single direction cannot cover the internal space of the entire housing 110 and then a heat dissipation dead corner is generated. Furthermore, the technical effects of optimizing the distribution of the air outlet 114, improving the coverage of the heat dissipation airflow, enhancing heat dissipation efficiency, and improving the safety and reliability of the electromagnetic heating device 100 are achieved.

In some embodiments, the first air outlet 1142 is only provided on the front side of the housing 110 or the rear side of the housing 110; the second air outlet 1144 is provided on both the left side of the housing 110 and the right side of the housing 110.

In this embodiment, the orientation of the air outlet 114 is further defined. Specifically, the second air outlet 1144 is provided on both the left side of the housing 110 and the right side of the housing 110. The first air outlet 1142 is only provided on one side of the front and rear sides of the housing 110. By defining the above distribution manner of the air outlet 114 in which air is discharged from three sides, it is possible to improve the intensity of the heat dissipation airflow by appropriately reducing the orientation of the air outlet 114 and the total area of the air outlet 114 on the basis of ensuring that the coverage of the internal space of the housing 110 by the heat dissipation airflow meets the heat dissipation requirements, to enhance the heat dissipation efficiency.

Furthermore, the first air outlet 1142 is only provided on the front side of the housing 110, and the rear side of the electromagnetic heating device 100 is often arranged close to the wall. Providing the first air outlet 1142 only on the front side of the housing 110 can avoid the phenomenon that the air outlet 114 is blocked by the wall and the air cannot be discharged smoothly. Furthermore, the technical effect of improving the practicality of electromagnetic heating device 100 is achieved.

As shown in FIG. 1 and FIG. 2, in some embodiments, the fan assembly 120 comprises: a first air supply part 122, spaced apart from the first air outlet 1142 and configured to deliver airflow to the first air outlet 1142; a second air supply part 124, arranged between the first air supply part 122 and the first air outlet 1142 and configured to deliver airflow to the second air outlet 1144.

In this embodiment, the fan assembly 120 comprises the first air supply part 122 and the second air supply part 124. Specifically, the first air supply part 122 is spaced apart from the first air outlet 1142, and the second air supply part 124 is provided between the first air outlet 1142 and the first air supply part 122. Taking only providing the first air outlet 1142 on the front side of the housing 110 as an example, the first air supply part 122 is provided near the rear side of the housing 110, and the second air supply part 124 is provided on the front side of the first air supply part 122. Taking providing the first air outlet 1142 on both of the front side and the rear side of the housing 110 as an example, the first air supply part 122 is provided in a central area, and the second air supply part 124 is provided on both of the front side and the rear side of the first air supply part 122.

The first air supply part 122 is configured to generate a first airflow flowing towards the first air outlet 1142, that is, the first airflow flows from the first air outlet 1142 towards the front side and/or the rear side of the housing 110 to cover the heating structure in the front and rear spaces of the first air supply part 122 through the first airflow. The second air supply part 124 simultaneously delivers a second airflow to the two second air outlets 1144 in the left and right sides of the housing 110, and the second airflow mainly carries away the heat from the heating structures on the left and right sides of the second air supply part 124. By arranging the second air supply part 124 between the first air supply part 122 and the first air outlet 1142, the first airflow and the second airflow can intersect and converge on the left and right sides of the second air outlet 1144, to improve the heat dissipation efficiency of the space on the left and right sides of the second air supply part 124. Furthermore, the technical effects of improving the heat dissipation effect of the electromagnetic heating device 100 and enhancing the safety and reliability of electromagnetic heating device 100 are achieved.

Furthermore, the heating structures within the housing 110 are concentrated on the left and right sides of the second air supply part 124, to achieve centralized heat dissipation through the intersecting first and second airflows.

In FIG. 2, the area pointed to by arrow *a* is the arrangement area of the first air supply part, the area pointed to by arrow b is the arrangement area of the second air supply part, and the area pointed to by arrow c is the area on the left and right sides of the second air supply part, that is, the area where the first airflow and the second airflow intersect and converge.

The thick arrows indicate the flow directions of the first airflow and the second airflow.

In some embodiments, a plurality of second air supply parts 124 are provided between the first air supply part 122 and the first air outlet 1142.

In this embodiment, a plurality of second air supply parts 124 are provided between the first air supply part 122 and the first air outlet 1142. Each second air supply part 124 delivers the second airflow to the second air outlets 1144 on both the left and right sides, to jointly conduct heat dissipation for the heating structures on the left and right sides through the plurality of second air supply parts 124.

By arranging a plurality of second air supply parts 124 between the first air supply part 122 and the first air outlet 1142, the heat dissipation pressure on the left and right sides can be shared, and thus this reduces the air supply demand of a single second air supply part 124, and then reduces the size of a single second air supply part 124 to avoid excessive occupation of the space on the left and right sides by an overly large second air supply part 124, to provide convenient conditions for the layout of the heating structures inside the housing 110. As a result, the technical effects of improving the utilization rate of the heat dissipation airflow and enhancing the heat dissipation efficiency are achieved.

In some embodiments, the air inlet 112 extends along a first direction, and the first air supply part 122 and the second air supply part 124 are distributed along the first direction; the first direction is from the front side of the housing 110 to the rear side of the housing 110.

In this embodiment, the shape of the air inlet 112 and the corresponding distribution manner of the air supply parts are described. Specifically, the air inlet 112 is strip-shaped, and the strip-shaped air inlet 112 extends along the first direction at the bottom of the housing 110. The first direction is from the front side of the housing 110 to the rear side of the housing 110, that is, the thickness direction of the housing 110. On this basis, the first air supply part 122 and the second air supply part 124 further extend along the thickness direction, to reduce the occupation of the space on the left and right sides of the air supply parts as much as possible, and provide convenient conditions for the rational layout of the heating structures.

Furthermore, the air inlet 112 is distributed along the middle line of the housing 110, to divide the space into two symmetrical spaces on the left and right sides of the air inlet 112, and thus this enhances the uniformity of the heat dissipation airflow, reduces the possibility of the appearance of obvious strong heat dissipation area and weak heat dissipation area, and further enhance the reliability of heat dissipation.

As shown in FIG. 2 and FIG. 3, in some embodiments, the first air supply part 122 comprises: a first fan 1222, positioned opposite the air inlet 112; and a first air guiding rib 1224, surrounding the first fan 1222 and comprising a first opening 1226 that faces the area between the second air supply part 124 and the second air outlet 1144.

In this embodiment, the structure of the first air supply part 122 is described. Specifically, the first air supply part 122 comprises a first fan 1222 and a first air guiding rib 1224. The intake side of the first fan 1222 faces the air inlet 112 at the bottom of the housing 110, while the discharge side of the first fan 1222 faces all the directions of the first fan 1222. The first fan 1222 draws air in from the air inlet 112 and discharges the pressurized air to the surrounding area. The first air guiding rib 1224 is provided on the peripheral side of the first fan 1222 and surrounds the first fan 1222, and the first air guiding rib 1224 is provided with a first opening 1226. The first opening 1226 avoids the second air supply part 124 and faces the left and right sides of the second air supply part 124. When the first fan 1222 operates, the airflow that is diffused in all directions encounters the first air guiding rib 1224 and then converges towards the first opening 1226 along the first air guiding rib 1224. Finally, the airflow flows towards the area that the first opening 1226 faces to form the aforementioned first airflow.

Furthermore, the first air guiding rib 1224 comprises two first openings 1226, and one of the first openings 1226 faces the left front side of the first air supply part 122, namely, the area on the left side of the second air supply part 124, and the other first opening 1226 faces the right front side of the first air supply part 122, namely, the area on the right side of the second air supply part 124. The structure complexity of the air supply parts composed of the fan and the air guiding rib is relatively low, which can reduce process complexity and the cost of production and assembly.

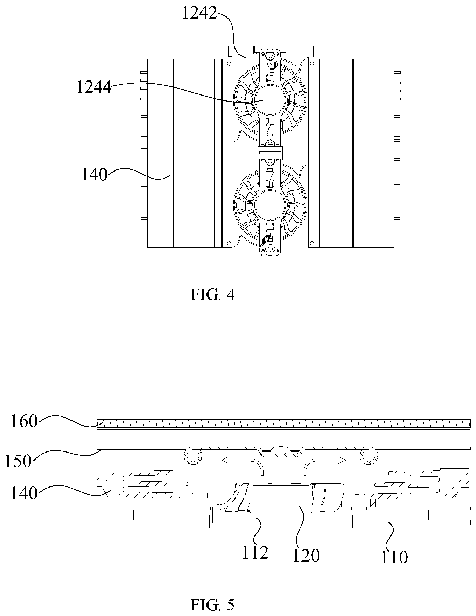

As shown in FIG. 2 and FIG. 4, in some embodiments, the second air supply part 124 comprises: a second fan 1242, positioned opposite the air inlet 112; and a second air guiding rib 1244, surrounding the second fan 1242 and comprising a second opening 1246 that faces the second air outlet 1144.

In this embodiment, the structure of the second air supply part 124 is described. Specifically, the second air supply part 124 comprises a second fan 1242 and a second air guiding rib 1244. The intake side of the second fan 1242 faces the air inlet 112 at the bottom of the housing 110, while the discharge side of the second fan 1242 faces all the directions of the second fan 1242. The second fan 1242 draws air in from the air inlet 112 and discharges the pressurized air to the surrounding area. The second air guiding rib 1244 is provided on the peripheral side of the second fan 1242 and surrounds the second fan 1242, and the second air guiding rib 1244 is provided with a second opening 1246. The second opening 1246 faces the two second air outlets 1244 on the left and right sides of the second air supply part 124. When the second fan 1242 operates, the airflow that is diffused to all directions encounters the second air guiding rib 1244 and then converges towards the second opening 1246 along the second air guiding rib 1244. Finally, the airflow is discharged to the second air outlets 1144 to form the aforementioned second airflow.

Furthermore, the second air guiding rib 1244 comprises two second openings 1246, and one of the second openings 1246 faces the area on the left side of the second air supply part 124 and delivers airflow to the second air outlet 1144 on the left side of the housing 110, and the other second opening 1246 faces the area on the right side of the second air supply part 124 and delivers airflow to the second air outlet 1144 in the right side of the housing 110. Likewise, the structure complexity of the air supply parts composed of the fan and the air guiding rib is relatively low, which can reduce process complexity and the cost of production and assembly.

In some embodiments, both the first fan 1222 and the second fan 1242 are axial fans.

In this embodiment, axial fans are selected as both the first fan 1222 and the second fan 1242. The axial fans have the characteristic that the internal airflow is parallel to the axial direction of a wind wheel, and the output airflow approaches the radial direction of the wind wheel. This characteristic allows them to adapt to the requirements of bottom air intake and peripheral air exhaust. Additionally, axial fans have a relatively low requirement for size in a height direction, and selecting the axial fan helps reduce the thickness of the electromagnetic heating device 100, and then reduces the difficulty of arranging and storing the electromagnetic heating device 100, and improves the practicality of the electromagnetic heating device 100.

As shown in FIG. 1, in some embodiments, the impeller diameter of the first fan 1222 is greater than that of the second fan 1242.

In this embodiment, based on the previous embodiment, the impeller diameter of the first fan 1222 is a first diameter, and the impeller diameter of the second fan 1242 is a second diameter. Here, the first diameter is greater than the second diameter.

By providing the first fan 1222 with a larger impeller diameter, the space on the left and right sides of the first air supply part 122 can be fully utilized to generate strong first airflow by increasing the impeller size, to enhance the heat dissipation effect on the left and right sides of the second air supply part 124.

By providing the second fan 1242 with a smaller impeller diameter, it is possible to avoid excessive occupation of the space on the left and right sides by the impeller, reduce the possibility of interference between the second air supply part 124 and the heating structures, and provide convenient conditions for arranging the heating structures on the left and on the right.

As shown in FIG. 1 and FIG. 5, in some embodiments, the electromagnetic heating device 100 further comprises a main board 130 provided between the air outlet 114 and the fan assembly 120.

In this embodiment, the aforementioned heating structures comprise a main board 130, and the main board 130 comprises a PCB (Printed Circuit Board), and a control chip, a power supply unit, a sensor, a switch tube, etc. provided on the PCB. The main board 130 is configured to control the working status of the electromagnetic heating device 100 to meet the automation and intelligence requirements of the electromagnetic heating device 100. And the main board 130 generates a large amount of heat after being powered on. If this heat cannot be dissipated in time to the outside, problems such as the circuit breakage of the main board 130, melting and even combustion may occur. In this regard, the present application arranges the main board 130 between the air outlet 114 and the fan assembly 120, specifically between the second air supply part 124 and the second air outlet 1144, to jointly cool the main board 130 through the aforementioned first airflow and second airflow, to reduce the possibility of the occurrence of the above problems of the main board 130 and then achieve the technical effect of improving the safety and reliability of the electromagnetic heating device 100.

In some embodiments, the electromagnetic heating device 100 further comprises a heat sink 140, arranged on the main board 130.

In this embodiment, the electromagnetic heating device 100 further comprises a heat sink 140, arranged on the main board 130 and located within the coverage range of the first airflow and the second airflow. The heat sink 140 has excellent thermal conductivity and an aluminum alloy heat sink 140 can be specifically chosen. During operation, the heat generated by the main board 130 is transferred to the heat sink 140 through contact. As the first airflow and the second airflow flow through the heat sink 140, the heat inside the heat sink 140 is quickly dissipated into the first airflow and the second airflow, to accelerate the heat dissipation efficiency of the main board 130, and then enhance the heat dissipation effect without changing fan power.

In some embodiments, the housing 110 comprises: a bottom plate 116, with the air inlet 112 arranged in the bottom plate 116; a side plate 118, which is connected to the bottom plate 116 and surrounds the bottom plate 116. The air outlet 114 is arranged on the side plate 118.

In this embodiment, the structure of the housing 110 is described. Specifically, the housing 110 comprises a bottom plate 116 and a side plate 118. The air inlet 112 is provided on the bottom plate 116. The side plate 118 surrounds the bottom plate 116, and the air outlet 114 is provided in the side plate 118. The bottom plate 116 and the side plate 118 enclose a cavity body. The main board 130, the fan assembly 120, and the heat sink 140 are all provided within the cavity body to conceal and protect the abovementioned internal structures through the housing 110.

The side plate 118 is detachably provided on the bottom plate 116. By setting the detachable side plate 118, firstly, the processing difficulty of the housing 110 can be reduced, and secondly, when a side plate 118 on a certain side is damaged or the air outlet 114 on it is blocked, users can replace or clean the side plate 118 by detaching the corresponding side plate 118. This reduces the maintenance difficulty of the housing 110 and provides convenience for users.

In some embodiments, the electromagnetic heating device 100 further comprises a partition plate 150, which is connected to the side plate 118 and spaced apart from the bottom plate 116. The fan assembly 120, the main board 130, and the heat sink 140 are all located between the partition plate 150 and the bottom plate 116.

In this embodiment, the electromagnetic heating device 100 further comprises a partition plate 150. The partition plate 150 is connected to the side plate 118, and the partition plate 150 is spaced apart from the bottom plate 116. The partition plate 150 is located at the top of the fan assembly 120, the main board 130, and the heat sink 140. By providing the partition plate 150, it can cooperate with the bottom plate 116, the side plate 118, and the aforementioned air guiding rib to enclose an air supply channel. Firstly, it can increase the airflow intensity by collecting the airflow to enhance the heat dissipation effect, and secondly, it can prevent the airflow from leaking out from the top, to further improve the heat dissipation effect and reduce energy consumption.

In some embodiments, the electromagnetic heating device 100 further comprises a panel 160 arranged at the top of the housing 110.

In this embodiment, the electromagnetic heating device 100 further comprises a panel 160. The panel 160 is placed above the side plate 118. Firstly, users cover the opening at the top of the housing 110 to conceal the working structures inside the housing 110, and secondly, the panel 160 is configured to support a target container. Specifically, an electromagnetic coil inside the housing 110 forms a heating area on the panel 160. The target container is placed above the heating area. Under the action of the electromagnetic field generated by the electromagnetic coil, the target container gradually heats up, to cook the food ingredients inside it at a high temperature.

It needs to be indicated that in the claims, specification and the accompanying drawings of the specification of the present application, the term of "a plurality of" refers to two or more than two, unless otherwise clearly defined. The orientation or position relations indicated by the terms of "upper", "lower" and the like are based on the orientation or position relations shown in the accompanying drawings, and are just intended to conveniently describe the present application and simplify the description, and are not intended to indicate or imply that the devices or units as indicated should have specific orientations or should be configured or operated in specific orientations, and then such description should not be construed as limitations to the present application. The terms "connect", "install", "fix" and the like should be understood in a broad sense, for example, the term "connect" can be a fixed connection between a plurality of objects, a detachable connection between a plurality of objects, or an integral connection; it can be a direct connection between a plurality of objects, or an indirect connection between a plurality of objects through an intermediate medium. For those of ordinary skills in this field, the specific meanings of the above terms in the present application can be understood according to the specific situations of the above data.

In the claims, the description and the accompanying drawings of the description of the present application, the description of the terms of "an embodiment", "some embodiments", "specific embodiment" and the like is intended to mean that the specific features, structures, materials or characteristics described in combination with the embodiments or examples are included in at least one embodiment or example of the present application. In the claims, the description and the accompanying drawings of the description, the illustrative expression of the above terms may not indicate the same embodiment or example. In addition, the specific features, structures, materials or characteristics as described may be combined with each other in an appropriate method in one or more of any embodiments or examples.

The above-mentioned are merely some embodiments of the present application and not intended to limit the present application, and for one skilled in the art, various modifications and changes may be made to the present application. Any modifications, equivalent substitutions, improvements and so on made within the spirit and principle of the present application should be covered within the scope of protection of the present application.

## Claims

1. An electromagnetic heating device, comprising:
a housing comprising an air inlet and an air outlet, wherein the air inlet is located at the bottom of the housing, and the air outlet is located on a peripheral side of the housing; and
a fan assembly, disposed inside the housing and opposite to the air inlet, and configured to generate an airflow that diffuses toward the peripheral side of the fan assembly.

2. The electromagnetic heating device according to claim 1, wherein the air outlet comprises:
a first air outlet located at a front side and/or a rear side of the housing; and
a second air outlet located at a left side and/or the right side of the housing.

3. The electromagnetic heating device according to claim 2, wherein:
the first air outlet is only provided on the front side of the housing or the rear side of the housing; and
the second air outlet is provided on both the left side of the housing and the right side of the housing.

4. The electromagnetic heating device according to claim 2, wherein the fan assembly comprises:
a first air supply part, spaced apart from the first air outlet, and configured to deliver airflow to the first air outlet; and
a second air supply part, arranged between the first air supply part and the first air outlet, configured to deliver airflow to the second air outlet.

5. The electromagnetic heating device according to claim 4, wherein a plurality of the second air supply parts are provided between the first air supply part and the first air outlet.

6. The electromagnetic heating device according to claim 4, wherein:
the air inlet extends along a first direction, and the first air supply part and the second air supply part are distributed along the first direction; and
the first direction is from the front side of the housing to the rear side of the housing.

7. The electromagnetic heating device according to claim 4, wherein the first air supply part comprises:
a first fan, positioned opposite the air inlet; and
a first air guiding rib, surrounding the first fan and comprising a first opening that faces the area between the second air supply part and the second air outlet.

8. The electromagnetic heating device according to claim 7, wherein the second air supply part comprises:
a second fan, positioned opposite the air inlet; and
a second air guiding rib, surrounding the second fan and comprising a second opening that faces the second air outlet.

9. The electromagnetic heating device according to claim 8, wherein both the first fan and the second fan are axial fans.

10. The electromagnetic heating device according to claim 9, wherein the impeller diameter of the first fan is greater than that of the second fan.

11. The electromagnetic heating device according to any one of claims 1 to 10, further comprising:
a main board provided between the air outlet and the fan assembly.

12. The electromagnetic heating device according to claim 11, further comprising:
a heat sink, arranged on the main board.

13. The electromagnetic heating device according to claim 12, wherein the housing comprises:
a bottom plate, with the air inlet arranged on the bottom plate; and
a side plate, connected to the bottom plate and surrounding the bottom plate, wherein the air outlet is arranged on the side plate.

14. The electromagnetic heating device according to claim 13, further comprising:
a partition plate, connected to the side plate and spaced apart from the bottom plate, wherein the fan assembly, the main board, and the heat sink are all located between the partition plate and the bottom plate.

15. The electromagnetic heating device according to any one of claims 1 to 10, further comprising:
a panel, arranged at the top of the housing.
